# EUROPÄISCHE PATENTSCHRIFT

(11) **EP 1 360 692 B1**
(45) Veröffentlichungstag und Bekanntmachung des Hinweises auf die Patenterteilung: **05.07.2006**
(21) Anmeldenummer: 02701239.2
(22) Anmeldetag: 24.01.2002
(51) Int. Cl.: G11C 11/16, G11C 11/15

(54) **VERFAHREN ZUM BESCHREIBEN MAGNETORESISTIVER SPEICHERZELLEN UND MIT DIESEM VERFAHREN BESCHREIBBARER MAGNETORESISTIVER SPEICHER**
METHOD FOR WRITING INTO MAGNETORESISTIVE MEMORY CELLS AND MAGNETORESISTIVE MEMORY WHICH CAN BE WRITTEN INTO ACCORDING TO SAID METHOD
PROCEDE POUR ECRIRE DANS DES CELLULES DE MEMOIRES MAGNETORESISTIVES, ET MEMOIRESMAGNETORESISTIVES DANS LESQUELLES ON PEUT ECRIRE SELON CE PROCEDE

(30) Priorität: 16.02.2001 DE 10107380
(43) Veröffentlichungstag der Anmeldung: 12.11.2003
(73) Patentinhaber: Infineon Technologies AG, 81669 München (DE)
(72) Erfinder: FREITAG, Martin, 80337 München (DE); MIETHANER, Stefan, 93051 Regensburg (DE); RABERG, Wolfgang, Fishkill, NY 12524 (US)
(74) Vertreter: Kottmann, Heinz Dieter
(86) Internationale Anmeldenummer: PCT/DE2002/000255
(87) Internationale Veröffentlichungsnummer: WO 2002/067266

(56) Entgegenhaltungen:
- US-A- 3 375 503
- US-A- 4 547 866
- US-A- 5 864 498

## Beschreibung

Die Erfindung betrifft ein Verfahren zum Beschreiben von magnetoresistiven Speicherzellen eines MRAM-Speichers, die jeweils aus einem Stapel einer hartmagnetischen Schicht, eines Tunneloxids und einer weichmagnetischen Schicht bestehen sowie eine mit diesem Verfahren beschreibbare MRAM-Speicheranordnung

Bei magnetoresistiven Speichern (MRAM) liegt der Speichereffekt im magnetisch veränderbaren elektrischen Widerstand der Speicherzelle (MTJ). Bei einer Ausführung liegt eine magnetoresistive Speicherzelle an der Kreuzung zweier Leiter, einer Bitleitung BL und einer Wortleitung WL, die im allgemeinen orthogonal zueinander angeordnet sind. An der Kreuzungsstelle zwischen diesen Leitern befindet sich ein Mehrschichtsystem, welches aus der Übereinanderstapelung eines weich- und hartmagnetischen Materials (ML-free und ML-fixed) besteht, zwischen denen sich ein Tunneloxid (TL) befindet (Crosspoint-Konzept). Die Informationsspeicherung geschieht dadurch, dass die Magnetisierung der weichmagnetischen Schicht (ML-free) gegenüber der Magnetisierungsrichtung der hartmagnetischen Schicht (ML-fixed) gedreht wird. Die hierzu erforderlichen Magnetfelder werden durch Ströme I_{WL} und I_{BL} erzeugt, die jeweils durch die Wortleitung WL und die Bitleitung BL fliessen und sich an deren Kreuzungspunkt überlagern.

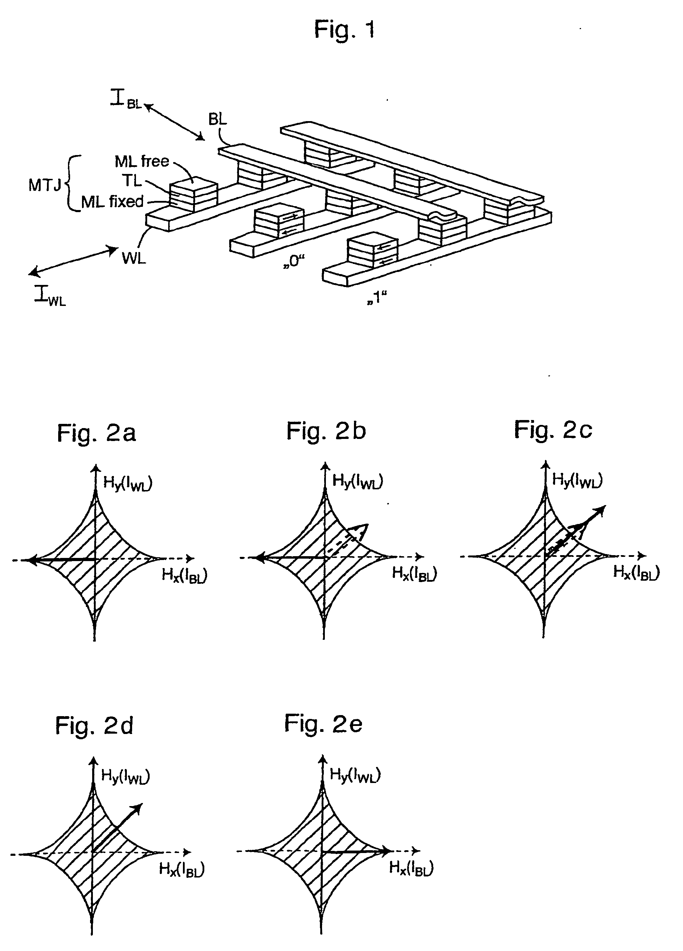

In der beiliegenden Fig. 1 ist ein Abschnitt einer derart aufgebauten MRAM-Speicheranordnung gezeigt, die aus einer Matrixanordnung der oben beschriebenen Speicherzellen besteht. Um sicherzustellen, dass nur eine gewählte Zelle MTJ beschrieben wird, muss das Magnetfeld genau so gross gewählt werden, dass die Überlagerung der Magnetfelder der Ströme I_{WL} und I_{BL} durch die selektierte Wortleitung und Bitleitung zum Schalten der Magnetisierung ausreicht, jedoch so klein gewählt werden, dass weder benachbarte Zellen, noch Zellen, die sich an den selektierten Leitungen befinden, geschaltet werden. Dieses Verfahren wird auch als "Half-Select"-Verfahren) bezeichnet.

Das Lesen von MRAM-Zellen erfolgt über die Bestimmung des Widerstands der jeweiligen MTJs. Bei paralleler Orientierung der Magnetisierungsrichtungen von ML-free und ML-fixed ist der (Tunnel-)Widerstand der Zelle klein, während bei antiparalleler Orientierung dieser Widerstand groß ist. Somit kann man, wie in Fig. 1 angedeutet, der parallelen Orientierung der Magnetisierungsrichtungen von ML-free und ML-fixed eine logische "1" und der antiparallelen Orientierung der Magnetisierungsrichtungen eine logische "0" zuordnen.

Bei häufigem Beschreiben eines MTJs wurde eine Alterung der Zellen registriert. Dies bedeutet, dass mit steigender Anzahl von Schreibzyklen der Unterschied des Widerstands der MTJs jeweils zwischen paralleler Orientierung ("1") und antiparalleler Orientierung ("0") sinkt und somit der Informationsinhalt der Zelle immer schwieriger zu bestimmen wird. Außerdem wird häufig beobachtet, dass zu beschreibende Zellen nicht zuverlässig schalten. Diese Probleme lassen sich mit dem bisher verwendeten "Half-Select"-Verfahren nicht lösen, und es sind auch keine anderen Lösungen bekannt.

Nachstehend werden die im Stand der Technik auftretenden Probleme noch genauer bezogen auf die Fig. 2 beispielhaft beim Einschreiben einer logischen "1" erläutert. Ohne äußeres Feld ist die Magnetisierung in dünnen magnetischen Schichten (hier von ML-free) entlang einer ausgezeichneten Richtung orientiert, der sogenannten leichten Achse, die in Fig. 2 gestrichelt gezeichnet ist. Der stark ausgezogen gezeichnete Pfeil in den Fig. 2a und 2b gibt somit die Magnetisierungsrichtung (von ML-free) der magnetoresistiven Speicherzelle MTJ solange keine Einwirkung eines durch einen Strom in der Bitleitung BL und/oder der Wortleitung WL erzeugten äußeren Magnetfeldes auftritt. Um die durch den stark ausgezogenen Pfeil in Fig. 2a und 2b angedeutete (Ruhe-)Magnetisierungsrichtung zu ändern, muss ein äußeres Feld angelegt werden, welches außerhalb des durch die schraffierte Fläche angedeuteten Schaltbereichs (der sogenannten Astroide) liegt. Schaltet man mit nur einer Feldkomponente (beispielsweise Hₓ) benötigt man relativ große Felder. Nutzt man dagegen beide Feldkomponenten Hₓ und H_{y}, benötigt man betragsmäßig kleinere Felder zum Schalten.

Somit wird gemäß den Fig. 2b und 2c ein Magnetfeld mit einer Komponente Hₓ und H_{y} durch einen in der Wortleitung WL fließenden Strom I_{WL} und einen in der Bitleitung BL fließenden Strom I_{BL} erzeugt (gestrichelter Pfeil in Fig. 2b). Dieses Feld muss solange anliegen, bis die Magnetisierungsrichtung (stark ausgezogener Pfeil) entlang der Richtung des durch I_{WL} und I_{BL} erzeugten Magnetfelds orientiert ist (Fig. 2c). Dann werden beide Ströme I_{WL} und I_{BL} ausgeschaltet, und es liegt kein Magnetfeld mehr von außen an (Fig. 2d). Man hofft dann, dass die Magnetisierungsrichtung (stark ausgezogener Pfeil) nun die in Fig. 2e skizzierte Ausrichtung, antiparallel zum Ausgangszustand (der Ruhe-Magnetisierungsrichtung gemäß Fig. 2a) einnimmt.

Da dieses Verfahren, wie schon erwähnt, nicht zuverlässig ist und zum Altern der Zelle führt, ist es Aufgabe der Erfindung, ein Verfahren zum Beschreiben magnetoresistiver Speicherzellen eines MRAM-Speichers zu ermöglichen, welches das Alterungsphänomen vermeidet, damit die Lebensdauer eines MRAM-Speichers vergrößert und verglichen mit dem üblichen Half-Select-Verfahren zuverlässiger schaltet sowie einen mit einem erfindungsgemäßen Verfahren beschreibbaren MRAM-Speicher anzugeben.

Diese Aufgabe wird anspruchsgemäß gelöst.

US-A-3,375,503 beschreibt und zeigt in den Figuren 1 und 2 eine Speicherzelle aus magnetostatisch gekoppelten magnetischen Dünnschichten, die so aufgebaut sind, dass sie einen magnetisch geschlossenen Magnetkreis bilden und deren leichte Magnetisierungsrichtung parallel zueinander ausgerichtet ist. Durch ein zeitlich versetztes Aufschalten der Schreibimpulse jeweils auf die Wortleitung und Bitleitung wird eine Drehung der Magnetisierungsrichtung der gesamten magnetischen Dünnfilmspeicherzelle in mehreren Schritten, nämlich in genau zwei Schritten in die gewünschte, einer "1" oder "0" entsprechende Magnetisierungsrichtung bewirkt. Da es sich bei der in dieser Druckschrift beschriebenen Speicherzelle nicht um eine MRAM-Speicherzelle, sondern um eine magnetische Dünnfilmspeicherzelle handelt, sind die physikalischen Mechanismen und auch die Aufgabenstellung, anders als bei dem vorliegenden Anmeldungsgegenstand.

Bei dem in der Druckschrift offenbarten Verfahren werden zunächst alle Bits entlang einer Wortleitung in die harte Magnetisierungsrichtung ausgerichtet. Um dabei die Information der Speicherzellen entlang besagter Wortleitung zu retten, sind Leseverstärker vorhanden, welche die ursprünglichen Zustände detektieren, so dass diese später zurückgeschrieben werden können (siehe Spalte 5, Zeilen 1 bis 28). Ferner offenbart die Druckschrift weiter, dass folglich der Wortleitungspuls beliebig groß ausgebildet sein kann.

US 5,864,498 offenbart einen ferromagnetischen Speicher mit einer weichmagnetischen Materialschicht und einer hartmagnetischen Materialschicht, zwischen denen sich eine nichtmagnetische leitende Schicht zum Beispiel aus Kupfer befindet. Auf diese Weise bildet die in dieser Druckschrift beschriebene Speicherzelle zwar eine MRAM-Speicherzelle, enthält aber zwischen der hart- und weichmagnetischen Schicht jeder Speicherzelle kein Tunneloxid, wie die gattungsgemäße Speicherzelle. Das hier sich stellende Problem der Alterung einer MTJ-Speicherzelle mit einem Tunneloxid zwischen hart- und weichmagnetischer Schicht tritt in dieser Weise bei der in US 5,864,498 beschriebenen Speicherzelle nicht auf.

Die obige Aufgabe wird gelöst durch ein Verfahren gemäß Anspruch 1.

Vorteilhafterweise wird bei diesem Verfahren in einem ersten Drehschritt, solange nur der Schreibstrom in der Wortleitung fließt, die Magnetisierungsrichtung der weichmagnetischen Schicht gegenüber ihrer ursprünglichen Magnetisierungsrichtung um einem Winkel zwischen 0 und 90° gedreht; in einem zweiten Drehschritt, wenn gleichzeitig die Schreibströme in der Wortleitung und der Bitleitung fließen, die Magnetisierungsrichtung der weichmagnetischen Schicht gegenüber ihrer ursprünglichen Magnetisierungsrichtung um einen Winkel zwischen 90° und 180° gedreht, und in einem dritten Drehschritt, wenn nur noch der Schreibstrom in der Bitleitung fließt, die Magnetisierungsrichtung der weichmagnetischen Schicht in den gewünschten Endzustand weitergedreht, bei dem sich die Magnetisierungs-richtung der weichmagnetischen Schicht um 180° gegenüber ihrer ursprünglichen Magnetisierungsrichtung unterscheidet.

Das erfindungsgemäße Verfahren kann dadurch vorteilhaft weitergebildet werden, dass die Schreibströme I_{WL} und I_{BL} der gewählten Speicherzelle jeweils in annähernd gleicher Impulsdauer und zeitlich gegeneinander versetzt aufgeschaltet werden.

Dann kann das erfindungsgemässe Verfahren so durchgeführt werden, dass zum Schreiben einer logischen "1" der Schreibstrom I_{BL} in der Bitleitung BL in der gleichen Stromflussrichtung wie der Schreibstrom I_{WL} in der Wortleitung WL fliesst und gegenüber dem Schreibstrom I_{WL} der Wortleitung WL verzögert aufgeschaltet wird.

Gemäß einem zweiten Aspekt der Erfindung wird die obige Aufgabe gelöst durch eine MRAM-Speicheranordnung gemäß Anspruch 4.

Darin sind die Schaltungsmittel der Schreibsteuerschaltung vorteilhafterweise so eingerichtet, dass sie in einem ersten Schritt zunächst nur den Schreibstrom der Wortleitung aufschalten, um die Magnetisierungsrichtung der weichmagnetischen Schicht gegenüber ihrer ursprünglichen Magnetisierungsrichtung um einen Winkel zwischen 0 und 90° zu drehen; in einem zweiten Schritt gleichzeitig den Schreibstrom sowohl der Wortleitung als auch der Bitleitung aufschalten, um die Magnetisierungsrichtung der weichmagnetischen Schicht gegenüber ihrer ursprünglichen Magnetisierungsrichtung um einen Winkel zwischen 90° und 180° zu drehen, und in einem dritten Schritt den Schreibstrom in der Wortleitung abschalten und nur noch den Schreibstrom in der Bitleitung fließen lassen, um die Magnetisierungsrichtung der weichmagnetischen Schicht in den gewünschten der logischen "0" oder "1" entsprechenden Endzustand weiterzudrehen, bei dem sich die Magnetisierungsrichtung der weichmagnetischen Schicht um 180° gegenüber ihrer ursprüngichen Magnetisierungsrichtung unterscheidet.

Nachstehend wird das erfindungsgemäße Verfahren in einem Ausführungsbeispiel bezogen auf die Zeichnung näher erläutert. Die Zeichnungsfiguren zeigen im einzelnen:
- Fig. 1: schematisch und perspektivisch den grundsätzlichen Aufbau einer MRAM-Speicheranordnung,
- Fig. 2a-2e: grafisch das Schalten der Magnetisierungsrichtung beim bekannten Half-Select-Verfahren,
- Fig. 3a-3h: ein Ausführungsbeispiel eines erfindungsgemäßen Schreibverfahrens durch Anlegen eines zeitgesteuerten äußeren Magnetfeldes, und
- Fig. 4: die Umsetzung des in Fig. 3 grafisch dargestellten Verfahrens in ein Impuls-Zeitdiagramm, welches die gegeneinander zeitversetzten Stromimpulse durch die Wortleitung und die Bitleitung jeweils beim Schreiben einer logischen "1" und einer logischen "0" veranschaulicht.

Die nachstehende Beschreibung setzt beispielhaft eine gemäß Fig. 1 aufgebaute MRAM-Speicheranordnung voraus. Es muß jedoch bemerkt werden, dass das erfindungsgemäße Verfahren auch bei anders aufgebauten MRAMs anwendbar ist, bei denen die magnetoresistive Speicherzelle nicht ummittelbar am Kreuzungspunkt der Bitleitung mit der Wortleitung angeordnet ist und bei denen zusätzlich ein Auswahltransistor oder eine Auswahldiode durch eine entsprechende Auswahlleitung angesteuert werden.

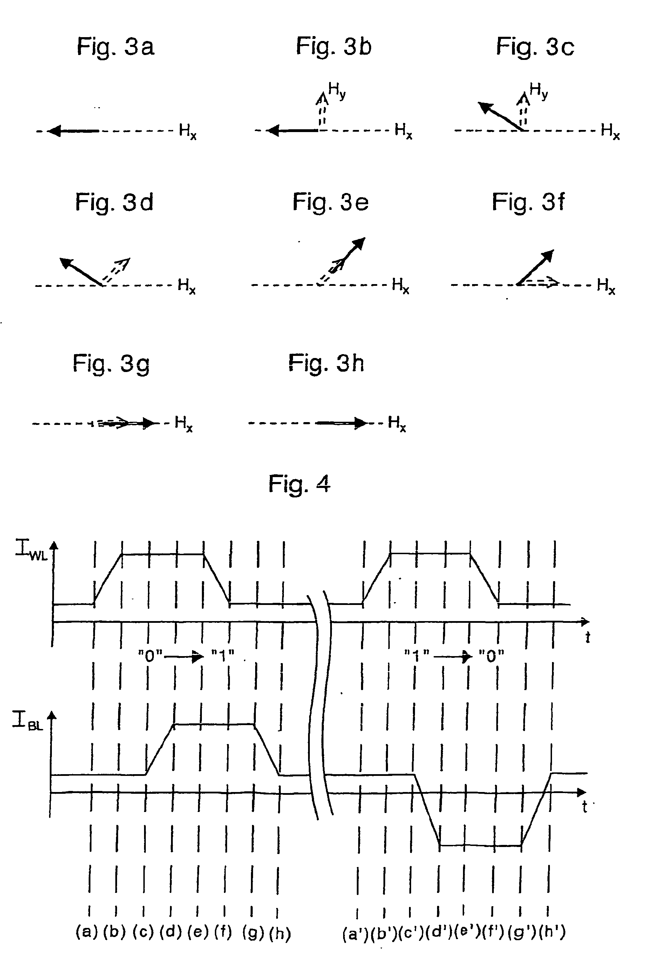

Bei dem in Fig. 3 grafisch und in Fig. 4 durch ein Impuls-Zeitdiagramm veranschaulichten erfindungsgemäßen Schreibverfahren zum Beschreiben magnetoresistiver Speicherzellen eines MRAM-Speichers werden die Feldkomponenten Hₓ und H_{y} bzw. die Zeiten des Aufschaltens der Wortleitungs- und Bitleitungsströme I_{WL} und I_{BL} exakt so kontrolliert, dass das im bekannten Half-Select-Verfahren stattfindende "Schalten" der Magnetisierung in einen Rotationsprozess der Magnetisierung überführt wird, der wesentlich zuverlässiger und langlebiger arbeitet.

In den grafischen Darstellungen der Fig. 3a bis Fig. 3h, die die zeitliche Abfolge der Rotation der Magnetisierung beim Schreiben einer logischen "1" veranschaulichen, ist zur Vereinfachung die Astroide weggelassen und nur die leichte Achse durch eine gestrichelte Gerade angedeutet. Wie in Fig. 2 ist die Magnetisierung der Speicherzelle MTJ durch einen stark schwarz gezeichneten Pfeil und das sich aus den Magnetfeldkomponenten H_{y} und Hₓ zusammensetzende durch den Wortleitungsstrom I_{WL} und den Bitleitungsstrom I_{BL} induzierte Magnetfeld durch einen doppelt gestrichelten Pfeil dargestellt. Fig. 3a veranschaulicht die Ausgangssituation, die der in Fig. 2a dargestellten Ausgangssituation entspricht. In den Fig. 3b und 3c liegt zunächst, induziert durch die Ströme I_{WL} und I_{BL}, ein Magnetfeld H_{y} nur in y-Richtung an, welches die Magnetisierung der MRAM-Speicherzelle MTJ zunächst um einen Winkel zwischen 0° und 90° dreht (Fig. 3c). Dann wird, wenn beide Ströme I_{WL} und I_{BL} fließen, das Magnetfeld mit etwa gleich großen Komponenten Hₓ und H_{y} in x- und y-Richtung erzeugt, wodurch sich die Magnetisierungsrichtung (starker Pfeil) weiter dreht und einen Winkel im Bereich zwischen 90° und 180° annimmt (Fig. 3e). Endlich wird durch ein Magnetfeld, das eine lediglich in x-Richtung weisende Komponente Hₓ hat, die Magnetisierungsrichtung gemäß den Fig. 3f und 3g weiter gedreht, bis sie schließlich in x-Richtung (180°) gedreht ist. Fig. 3h zeigt den stromlosen Endzustand, der den Informationsgehalt gemäß einer logischen "1" der MRAM-Speicherzelle MTJ angibt.

Das Zeitdiagramm in Fig. 4 zeigt in seiner linken Hälfte die Zeitfolge a - h des Wortleitungsstroms I_{WL} und des Bitleitungsstroms I_{BL} zum Schreiben einer logischen 1, und die Zeitpunkte a - h entsprechen der in Fig. 3a - h gezeigten Folge der dadurch sich drehenden Magnetisierung, wie sie oben beschrieben wurde.

Die rechte Hälfte der Fig. 4 zeigt in gleicher Weise Schritte a' - h' der zeitlichen Abfolge der Ströme I_{WL} und I_{BL} zum Schreiben einer logischen "0" in eine MRAM-Speicherzelle MTJ. Es ist ersichtlich, dass zwischen den Zeitpunkten e und h' der Bitleitungsstrom I_{BL} in umgekehrter Richtung durch die Bitleitung BL fließt.

Zur Durchführung der erfindungsgemäß vorgeschlagenen schrittweisen Rotation der Magnetisierung ist es somit unbedingt nötig, dass der Strom I_{WL} durch die Wortleitung WL und der Strom I_{BL} durch die Bitleitung BL zeitlich gegeneinander definiert versetzt sind. Wenn zum Beispiel der Wortleitungsstrom und der Bitleitungsstrom gleiche Einschaltdauer haben, so kann der Bitleitungsstrom I_{BL} z.B. etwa um die halbe Einschaltdauer gegenüber dem Wortleitungsstrom I_{WL} verzögert angelegt werden, wobei die Stromflussrichtung des Bitleitungsstroms I_{BL} beim Schreiben einer logischen "0" umgekehrt ist gegenüber der Stromflussrichtung von I_{BL} beim Schreiben einer logischen "1".

Die erfindungsgemäße und oben anhand der Figuren beschriebene kontrollierte Rotation der Magnetisierung der MRAM-Speicherzelle MTJ vermeidet das beim bekannten Half-Select-Verfahren auftretende Alterungsphänomen, verlängert dadurch die Lebensdauer der MRAM-Zellen und schaltet zuverlässiger im Vergleich mit dem herkömmlichen Verfahren. Mit Kenntnis des oben beschriebenen erfindungsgemäßen Verfahrens kann ein Fachmann ohne weiteres eine Schreibsteuerschaltung für einen nach dem erfindungsgemäßen Verfahren beschreibbaren MRAM-Speicher, das heißt Schaltungsmittel angeben, die die Schreibströme I_{WL} und I_{BL} durch die Wortleitung WL und die Bitleitung BL zeitlich gegeneinander versetzt aufschalten, so wie es beispielhaft in Fig. 4 dargestellt ist, so dass die Magnetisierungsrichtung der selektierten Speicherzelle in mehreren aufeinanderfolgenden Schritten in die jeweils zum Schreiben einer logischen "0" oder "1" gewünschte Richtung gedreht wird.

### Bezugszeichenliste

- BL: Bitleitung
- WL: Wortleitung
- ML-free: freie Magnetlage (weichmagnetische Schicht)
- ML-fixed: feste Magnetlage (hartmagnetische Schicht)
- TL: Tunnellage (Tunneloxid)
- MTJ: Magnetic Tunnel Junction (magnetoresistive Speicherzelle)
- I_{BL}: Strom durch die Bitleitung BL
- I_{WL}: Strom durch die Wortleitung WL
- Hₓ: Magnetfeldkomponente in x-Richtung
- H_{y}: Magnetfeldkomponente in y-Richtung
- a - h: aufeinander Schritte beim Drehen der Magnetisierungsrichtung
- a' - h': aufeinander Schritte beim Drehen der Magnetisierungsrichtung

## Patentansprüche

1. Verfahren zum Beschreiben von jeweils aus einem Stapel einer hartmagnetischen Schicht (MLfixed), eines Tunneloxids (TL) und einer weichmagnetischen Schicht (MLfree) bestehenden magnetoresistiven Speicherzellen (MTJ) eines MRAM-Speichers, bei dem Schreibströme (I_{WL}, I_{BL}) jeweils einer Wortleitung (WL) und einer Bitleitung (BL) in einem an sich bekannten "Half-select"-Verfahren aufgeschaltet werden, wobei das Magnetfeld genau so groß gewählt wird, dass die Überlagerung der durch jeden dieser Schreibströme (I_{WL}, I_{BL}) erzeugten Magnetfeldkomponenten (((Hₓ(I_{BL}), (H_{y}(I_{WL})) in jeder durch die entsprechende Wort- und Bitleitung (WL, BL) selektierten Speicherzelle (MTJ) zum Schalten der Magnetisierungsrichtung der weichmagnetischen Schicht (MLfree) gegenüber der Magnetisierungsrichtung der hartmagnetischen Schicht (MLfixed) ausreicht, jedoch so klein gewählt wird, dass weder benachbarte Zellen, noch Zellen, die sich an den selektierten Leitungen befinden, geschaltet werden, und wobei die Magnetfeldkomponenten (((Hₓ(I_{BL}), (H_{y}(I_{WL})) bzw. die Zeiten des Aufschaltens der Wortleitungs- und Bitleitungsströme zeitlich gegeneinander versetzt sind, so dass das im "Half-select"-Verfahren stattfindende Schalten der weichmagnetischen Schicht (MLfree) der selektierten Speicherzelle (MTJ) in mehreren aufeinanderfolgenden Schritten in die zum Schreiben einer logischen "0" oder "1" gewünschte Richtung dreht.

2. Verfahren nach Anspruch 1, bei dem
- in einem ersten Drehschritt, solange nur der Schreibstrom (I_{WL}) in der Wortleitung (WL) fließt, die Magnetisierungsrichtung der weichmagnetischen Schicht (MLfree) gegenüber ihrer ursprünglichen Magnetisierungsrichtung um einen Winkel zwischen 0° und 90° gedreht wird,
- in einem zweiten Drehschritt, wenn gleichzeitig die Schreibströme (I_{WL} und I_{BL}) in der Wortleitung (WL) und der Bitleitung (BL) fließen, die Magnetisierungsrichtung der weichmagnetischen Schicht (MLfree) gegenüber ihrer ursprünglichen Magnetisierungsrichtung um einen Winkel zwischen 90° und 180° gedreht wird, und
- in einem dritten Drehschritt, wenn nur noch der Schreibstrom (I_{BL}) in der Bitleitung (BL) fließt, die Magnetisierungsrichtung der weichmagnetischen Schicht (MLfree) in den gewünschten Endzustand weitergedreht wird, bei dem sich die Magnetisierungsrichtung der weichmagnetischen Schicht um 180° gegenüber ihrer ursprünglichen Magnetisierungsrichtung unterscheidet.

3. Verfahren nach Anspruch 1 oder 2, bei dem die Schreibströme (I_{WL}, I_{BL}) für die gewählte Speicherzelle (MTJ) jeweils in annähernd gleicher Impulsdauer und gegeneinander zeitlich um die halbe Impulsdauer versetzt aufgeschaltet werden.

4. MRAM-Speicheranordnung mit einem Array aus jeweils aus einem Stapel einer hartmagnetischen Schicht (MLfixed), eines Tunneloxids (TL) und einer weichmagnetischen Schicht (MLfree) bestehenden magnetoresistiven Speicherzellen (MTJ) und mit Wortleitungen (WL) und Bitleitungen (BL), wobei eine Schreibsteuerschaltung zum Aufschalten von Schreibströmen (I_{WL} und I_{BL}) jeweils auf die Wortleitung (WL) und Bitleitung (BL) einer zum Schreiben ausgewählten Speicherzelle (MTJ) in einem an sich bekannten "Half-select"-Verfahren vorgesehen ist, die die Schreibstörme (I_{WL}, I_{BL}) genau so erzeugt, dass die Überlagerung der durch die Schreibströme erzeugten Magnetfeldkomponenten (((Hₓ(I_{BL}), (H_{y}(I_{WL})) in jeder durch die entsprechende Wort- und Bitleitung (WL, BL) selektierten Wort- und Bitleitung (WL, BL) selektierten Speicherzelle (MTJ) zum Schalten der Magnetisierungsrichtung der weichmagnetischen Schicht (MLfree) gegenüber der Magnetisierungsrichtung der hartmagnetischen Schicht (MLfixed) ausreicht, jedoch nicht zum Schalten benachbarter Zellen oder von Zellen, die sich an den selektierten Leitungen befinden, führt, und
- wobei die Schreibsteuerschaltung Schaltungsmittel aufweist, die die Magnetfeldkomponenten (((Hₓ(I_{BL}), (H_{y}(I_{WL})) bzw. die Zeiten des Aufschaltens der Wortleitungs- und Bitleitungsströme (I_{WL}, I_{BL}) zeitlich gegeneinander versetzt, so dass das im "Half-select"-Verfahren stattfindende Schalten der Magnetisierung der weichmagnetischen Schicht (MLfree) der selektierten Speicherzelle (MTJ) in mehreren aufeinanderfolgenden Schritten in die zum Schreiben einer logischen "0" oder "1" gewünschte Richtung dreht.

5. MRAM-Speicheranordnung nach Anspruch 4, bei der die Schaltungsmittel der Schreibsteuerschaltung
- in einem ersten Schritt zunächst nur den Schreibstrom (I_{WL}) der Wortleitung (WL) aufschalten, um die Magnetisierungsrichtung der weichmagnetischen Schicht (MLfree) gegenüber ihrer ursprünglichen Magnetisierungsrichtung um einen Winkel zwischen 0° und 90° zu drehen;
- in einem zweiten Schritt gleichzeitig den Schreibstrom (I_{WL} und I_{BL}) sowohl der Wortleitung (WL) als auch der Bitleitung (BL) aufschalten, um die Magnetisierungsrichtung der weichmagnetischen Schicht (MLfree) gegenüber ihrer ursprünglichen Magnetisierungsrichtung um einen Winkel zwischen 90° und 180° zu drehen, und
- in einem dritten Schritt den Schreibstrom (I_{WL}) in der Wortleitung (WL) abschalten und nur noch den Schreibstrom (I_{BL}) in der Bitleitung (BL) fließen lassen, um die Magnetisierungsrichtung der weichmagnetischen Schicht (MLfree) in den gewünschten der logischen "0" oder "1" entsprechenden Endzustand weiterzudrehen, bei dem sich die Magnetisierungsrichtung der weichmagnetischen Schicht um 180° gegenüber ihrer ursprünglichen Magnetisierungsrichtung unterscheidet.

## Claims

1. Method for writing to magnetoresistive memory cells (MTJ) of an MRAM memory, said memory cells in each case comprising a stack of a hard-magnetic layer (Mlfixed), a tunnel oxide (TL) and a soft-magnetic layer (MLfree), in which write currents (I_{WL}, I_{BL}) are in each case impressed on a word line (WL) and a bit line (BL) in a "half-select" method known per se, the magnetic field being chosen precisely to be large enough that the superposition of the magnetic field components ((Hₓ(I_{BL}), (H_{y}(I_{WL})) generated by each of said write currents (I_{WL}, I_{BL}), in each memory cell (MTJ) selected by the corresponding word and bit line (WL, BL), suffices for switching the magnetization direction of the soft-magnetic layer (MLfree) relative to the magnetization direction of the hard-magnetic layer (MLfixed), but being chosen to be small enough that neither adjacent cells nor cells which are situated on the selected lines are switched, and the magnetic field components ((Hₓ(I_{BL}), (H_{y}(I_{WL})) or the times of impressing the word line and bit line currents being temporally offset with respect to one another in such a way that the switching of the soft-magnetic layer (MLfree) of the selected memory cell (MTJ) that takes place in the "half-select" method rotates in a plurality of successive steps in the direction desired for writing a logic "0" or "1".

2. Method according to Claim 1, in which
- in a first rotation step, as long as only the write current (I_{WL}) flows in the word line (WL), the magnetization direction of the soft-magnetic layer (MLfree) is rotated by an angle of between 0° and 90° relative to its original magnetization direction,
- in a second rotation step, if the write currents (I_{WL} and I_{BL}) simultaneously flow in the word line (WL) and the bit line (BL), the magnetization direction of the soft-magnetic layer (MLfree) is rotated by an angle of between 90° and 180° relative to its original magnetization direction, and
- in a third rotation step, if only the write current (I_{BL}) flows in the bit line (BL), the magnetization direction of the soft-magnetic layer (MLfree) is rotated further into the desired end state in which the magnetization direction of the soft-magnetic layer differs by 180° relative to its original magnetization direction.

3. Method according to Claim 1 or 2, in which the write currents (I_{WL}, I_{BL}) for the selected memory cell (MTJ) are impressed in each case in approximately the same pulse duration and in a manner temporally offset by half the pulse duration with respect to one another.

4. MRAM memory arrangement having an array comprising magnetoresistive memory cells (MTJ) in each case comprising a stack of a hard-magnetic layer (MLfixed), a tunnel oxide (TL) and a soft-magnetic layer (MLfree), and having word lines (WL) and bit lines (BL), a writing control circuit being provided for impressing write currents (I_{WL} and I_{BL}) in each case onto the word line (WL) and bit line (BL) of a memory cell (MTJ) selected for writing in a "half-select" method known per se, which circuit generates the write currents (I_{WL}, I_{BL}) precisely in such a way that the superposition of the magnetic field components ((Hₓ(I_{BL}), (H_{y}(I_{WL})) generated by the write currents, in each memory cell (MTJ) selected by the corresponding word and bit line (WL, BL), suffices for switching the magnetization direction of the soft-magnetic layer (MLfree) relative to the magnetization direction of the hard-magnetic layer (MLfixed), but does not lead to the switching of adjacent cells or of cells which are situated on the selected lines, and
- the writing control circuit having circuit means by which the magnetic field components ((Hₓ(I_{BL}), (H_{y}(I_{WL})) or the times of impressing the word line and bit line currents (I_{WL}, I_{BL}) are temporally offset with respect to one another in such a way that the switching of the magnetization of the soft-magnetic layer (MLfree) of the selected memory cell (MTJ) that takes place in the "half-select" method rotates in a plurality of successive steps in the direction desired for writing a logic "0" or "1".

5. MRAM memory arrangement according to Claim 4, in which the circuit means of the writing control circuit
- in a first step firstly only impress the write current (I_{WL}) on the word line (WL) in order to rotate the magnetization direction of the soft-magnetic layer (MLfree) by an angle of between 0° and 90° relative to its original magnetization direction;
- in a second step simultaneously impress the write current (I_{WL} and I_{BL}) both on the word line (WL) and on the bit line (BL) in order to rotate the magnetization direction of the soft-magnetic layer (MLfree) by an angle of between 90° and 180° relative to its original magnetization direction, and
- in a third step switch off the write current (I_{WL}) in the word line (WL) and only cause the write current (I_{BL}) to flow in the bit line (BL) in order to rotate further the magnetization direction of the soft-magnetic layer (MLfree) into the desired end state which corresponds to the logic "0" or "1" and in which the magnetization direction of the soft-magnetic layer differs by 180° relative to its original magnetization direction.

## Revendications

1. Procédé pour écrire dans des cellules (MTJ) magnétorésistives d'une mémoire MRAM constituées respectivement d'un empilement d'une couche (MLfixed) à magnétisme dur, d'un oxyde (TL) de tunnel et d'une couche (MLfree) à magnétisme doux, dans lequel on applique des courants (I_{WL}, I_{BL}) d'écriture respectivement à une ligne (WL) de mots et à une ligne (BL) de bits dans un procédé "half-select" connu en soi, en choisissant le champ magnétique exactement si grand que la superposition des composantes (((Hₓ(I_{BL}), (H_{y}(I_{WL})) de champ magnétique produites par ces courants (I_{WL}, I_{BL}) d'écriture dans chaque cellule (MTJ) de mémoire sélectionnée par la ligne de mots et la ligne de bits (WL, BL) correspondante suffit pour commuter la direction d'aimantation de la couche (MLfree) à magnétisme doux par rapport à la direction d'aimantation de la couche (MLfixed) à magnétisme dur, mais si petit que ni des cellules voisines ni des cellules qui se trouvent sur les lignes sélectionnées ne sont branchées, et dans lequel les composantes (((Hₓ(I_{BL}), (H_{y}(I_{WL})) du champ magnétique ou les durées de l'application des courants aux lignes de mots et aux lignes de bits sont décalées les unes par rapport aux autres, de manière à ce que la commutation ayant lieu dans le procédé "half-select" de la couche (MLfree) à magnétisme doux de la cellule (MTJ) de mémoire sélectionnée tourne en plusieurs stades successifs dans la direction souhaitée pour écrire un "0" ou un "1" logique.

2. Procédé suivant la revendication 1, dans lequel
- dans un premier stade de rotation, tant qu'il ne passe que le courant (I_{WL}) d'écriture dans la ligne (WL) de mots, la direction d'aimantation de la couche (MLfree) à magnétisme doux est tournée par rapport à sa direction d'aimantation initiale d'un angle compris entre 0° et 90°,
- dans un deuxième stade de rotation, lorsque les courants (I_{WL} et I_{BL}) d'écriture passent en même temps dans la ligne (WL) de mots et dans la ligne (BL) de bits, la direction d'aimantation de la couche (MLfree) à magnétisme doux est tournée par rapport à sa direction d'aimantation initiale d'un angle compris entre 90° et 180°, et
- dans un troisième stade de rotation, lorsqu'il ne passe plus que le courant (I_{BL}) d'écriture dans la ligne (BL) de bits, la direction d'aimantation de la couche (MLfree) à magnétisme doux est tournée davantage dans l'état final souhaité, dans lequel la direction d'aimantation de la couche à magnétisme doux diffère de 180° par rapport à sa direction d'aimantation initiale.

3. Procédé suivant la revendication 1 ou 2, dans lequel les courants (I_{WL}, I_{BL}) d'écriture pour la cellule (MTJ) de mémoire sélectionnée sont appliqués dans sensiblement la même durée d'impulsion et en étant décalés l'un par rapport à l'autre dans le temps de la demi-durée d'impulsion.

4. Dispositif de mémoire MRAM ayant un réseau de cellules (MTJ) de mémoire magnétorésistives constituées d'un empilement d'une couche (MLfixed) à magnétisme dur, d'un oxyde (TL) de tunnel et d'une couche (MLfree) à magnétisme doux et ayant des lignes (WL) de mots et des lignes (BL) de bits, un circuit de commande d'écriture pour appliquer des courants (I_{WL} et I_{BL}) d'écriture respectivement à la ligne (WL) de mots et à la ligne (BL) de bits d'une cellule (MTJ) de mémoire sélectionnée pour l'écriture étant prévu dans un procédé "half-select" en soi connu, qui produit les courants (I_{WL}, I_{BL}) d'écriture exactement de façon à ce que la superposition des composantes (((Hₓ(I_{BL}), (H_{y}(I_{WL})) de champ magnétique produites par les courants d'écriture dans chaque cellule (MTJ) de mémoire sélectionnée par la ligne (WL, BL) de mots et de bits correspondante suffit pour commuter la direction d'aimantation de la couche (MLfree) à magnétisme doux par rapport à la direction d'aimantation de la couche (MLfixed) à magnétisme dur, mais non pour commuter des cellules voisines ou des cellules qui se trouvent sur les lignes sélectionnées, et
- dans lequel le circuit de commande d'écriture a des moyens de circuit qui décalent les composantes (((Hₓ(I_{BL}), (H_{y}(I_{WL})) de champ magnétique ou les durées d'application des courants (I_{WL}, I_{BL}) de lignes de mots et de lignes de bits dans le temps les unes par rapport aux autres, de façon que la commutation ayant lieu dans le procédé "half-select" de l'aimantation de la couche (MLfree) à magnétisme doux de la cellule (MTJ) de mémoire sélectionnée tourne en plusieurs stades successifs dans la direction souhaitée pour l'écriture d'un "0" ou d'un "1" logique.

5. Dispositif dé mémoire MRAM suivant la revendication 4, dans lequel les moyens de circuit du circuit de commande d'écriture
- dans un premier stade, appliquent d'abord seulement le courant (I_{WL}) d'écriture à la ligne (WL) de mots pour faire tourner d'un angle compris entre 0° et 90° la direction d'aimantation de la couche (MLfree) à magnétisme doux par rapport à sa direction d'aimantation initiale ;
- dans un deuxième stade, appliquent en même temps le courant (I_{WL} et I_{BL}) d'écriture tant à la ligne (WL) de mots qu'également à la ligne (BL) de bits pour faire tourner d'un angle compris entre 90° et 180° la direction d'aimantation de la couche (MLfree) à magnétisme doux par rapport à sa direction d'aimantation initiale, et
- dans un troisième stade, interrompent le courant (I_{WL}) d'écriture dans la ligne (WL) de mots et ne laissent plus passer que le courant (I_{BL}) d'écriture dans la ligne (BL) de bits pour faire tourner davantage la direction d'aimantation de la couche (MLfree) à magnétisme doux dans l'état final souhaité correspondant à un "0" ou à "1" logique, dans lequel la direction d'aimantation de la couche à magnétisme doux se distingue de 180° de sa direction d'aimantation initiale.
